# EUROPEAN PATENT SPECIFICATION

(11) **EP 4 290 846 B1**
(45) Date of publication and mention of the grant of the patent: **06.08.2025**
(21) Application number: 23206458.4
(22) Date of filing: 26.10.2021
(51) Int. Cl.: H04N 25/616, H04N 25/771, H04N 25/79, H04N 25/671, H10F 39/00, H04N 25/78, H04N 25/65

(54) **IMAGING DEVICE AND IMAGING METHOD**
BILDGEBUNGSVORRICHTUNG UND BILDGEBUNGSVERFAHREN
DISPOSITIF D'IMAGERIE ET PROCÉDÉ D'IMAGERIE

(30) Priority: 09.11.2020 JP 2020186271
(43) Date of publication of application: 13.12.2023
(62) Divisional of application: 21889082.0
(73) Proprietor: Sony Semiconductor Solutions Corporation, Atsugi-shi, Kanagawa 243-0014 (JP)
(72) Inventor: ONO, Toshiaki, Atsugi-shi, 2430014 (JP)
(74) Representative: Müller Hoffmann & Partner

(56) References cited:
- US-A1- 2017 085 820
- US-A1- 2018 198 997
- YAVUZ DEG1?4ERLI ET AL: "Non-Stationary Noise Responses of Some Fully Differential On-Chip Readout Circuits Suitable for CMOS Image Sensors", IEEE TRANSACTIONS ON CIRCUITS AND SYSTEMS II: ANALOG AND DIGITAL SIGNAL PROCESSING, INSTITUTE OF ELECTRICAL AND ELECTRONICS ENGINEERS INC, 345 EAST 47 STREET , NEW YORK N Y 10017 , USA, vol. 46, no. 12, 1 December 1999 (1999-12-01), XP011013158, ISSN: 1057-7130

## Description

### TECHNICAL FIELD

The present technology relates to an imaging device and an imaging method, and for example, relates to an imaging device and an imaging method capable of further improving image quality.

### BACKGROUND ART

A camera-equipped mobile phone using an imaging element such as a charge coupled device (CCD) or a complementary metal oxide semiconductor (CMOS) image sensor, a digital still camera, a medical device such as an endoscope, and the like are known.

Patent Document 1 describes that in a global shutter operation, a reset potential of a floating diffusion is held in a first capacitor, and a signal potential after photodiode charges are transferred is held in a second capacitor. After the holding, the potentials held in the first and second capacitors are read by the first amplifier circuit and the second amplifier circuit, and it is proposed to remove reset noise (kTC noise) of the floating diffusion by taking a difference between these signals.
US 2018/198997 A1 relates to a solid-state imaging device which, in a voltage mode, simultaneously samples the pixel signal in all the pixels in a signal holding part serving as the pixel signal storage part, reads converted signals corresponding to readout signals held in a first signal holding capacitor and a second signal holding capacitor to a first signal line, reads converted signals corresponding to readout reset signals simultaneously in parallel to the second signal line, and supplies the same as a differential signal to a column readout circuit.
Yavuz Degerli, et al. relates to non-stationary responses of some fully differential on-chip readout circuits suitable for CMOS image sensors. A comparison of theoretical and experimental noise response of three amplifiers designed on a 0.7 µm standard CMOS technology is described.
US 2017/085820 A1 relates to an image sensor, comprising a pixel that has a photoelectric conversion element for performing photoelectric conversion and outputs an electrical signal, a reference signal output unit that outputs a reference signal, a level of which is changed, and an ADC that performs AD (Analog Digital) conversion for the electrical signal by counting time necessary for a change of the reference signal to a coincidence of the electrical signal output from the pixel and the reference signal output from the reference signal output unit.

### CITATION LIST

### PATENT DOCUMENT

Patent Document 1: Japanese Patent Application Laid-Open No. 2011-78104

### SUMMARY OF THE INVENTION

### PROBLEMS TO BE SOLVED BY THE INVENTION

According to Patent Document 1, in a case where there is an offset between the first amplifier circuit and the second amplifier circuit, there is a possibility that an error occurs in the CDS operation and noise deteriorates. Specifically, since the offset amount varies for each pixel, there is a possibility that a fixed pattern noise appears in the image and the image quality deteriorates.

There is also a possibility that random noise occurs in the amplifier circuit, and according to Patent Document 1, since noise occurs in the first and second amplifier circuits without correlation, there is a possibility that the noise of the amplifier circuits is not canceled even if a difference is directly taken. It is known that a transistor generates larger noise at a lower frequency, and there is a possibility that this low-frequency noise cannot be canceled.

It is desired to improve the image quality by removing the influence of the offset and noise of the amplifier circuit.

The present technology has been made in view of such a situation, and an object thereof is to remove an influence of an offset, noise, and the like of an amplifier circuit and to improve image quality.

### SOLUTIONS TO PROBLEMS

The invention is defined by the appended claims. The following aspects may include some but not all features as literally defined in the claims and are present for illustration purposes only.

An imaging device according to one aspect of the present technology is an imaging device including: a photoelectric conversion section that performs photoelectric conversion; a first capacitor that holds a first signal from the photoelectric conversion section; a second capacitor that holds a second signal from the photoelectric conversion section; a first reading section that reads the first signal held in the first capacitor; a second reading section that reads the second signal held in the second capacitor; a differential circuit in which the first signal from the first reading section is input at one end and the second signal from the second reading section is input at another end; and an initialization section that initializes the differential circuit.

An imaging method according to one aspect of the present technology is an imaging method including: holding a first signal from a photoelectric conversion section in a first capacitor; holding a second signal from the photoelectric conversion section in a second capacitor; reading the first signal held in the first capacitor; reading the second signal held in the second capacitor; initializing a differential circuit in which the first signal is input to one end and the second signal is input to another end; and comparing a difference between the first signal and the second signal with a ramp signal, by an imaging device.

In an imaging device and an imaging method according to one aspect of the present technology, a first signal from a photoelectric conversion section is held in a first capacitor, a second signal from the photoelectric conversion section is held in a second capacitor, the first signal held in the first capacitor is read, the second signal held in the second capacitor is read, a differential circuit in which the first signal is input to one end and the second signal is input to anther end is initialized, and a difference between the first signal and the second signal is compared with a ramp signal.

Note that the imaging device may be an independent device or an internal block constituting one device.

### BRIEF DESCRIPTION OF DRAWINGS

Fig. 1 is a diagram illustrating a configuration example of a digital camera.
Fig. 2 is a diagram illustrating a configuration example of an imaging device.
Fig. 3 is a circuit diagram in a first embodiment of the imaging device.
Fig. 4 is a diagram for explaining an operation of the imaging device.
Fig. 5 is a diagram for explaining a stacked structure of the imaging device.
Fig. 6 is a diagram for explaining a stacked structure of the imaging device.
Fig. 7 is a circuit diagram in a second embodiment of the imaging device.
Fig. 8 is a diagram for explaining an operation of the imaging device.
Fig. 9 is a circuit diagram in a third embodiment of the imaging device.
Fig. 10 is a circuit diagram in a fourth embodiment of the imaging device.
Fig. 11 is a diagram for explaining an operation of the imaging device.
Fig. 12 is a diagram for explaining an operation in a fifth embodiment of the imaging device.
Fig. 13 is a view depicting an example of a schematic configuration of an endoscopic surgery system.
Fig. 14 is a block diagram depicting an example of a functional configuration of a camera head and a camera control unit (CCU).
Fig. 15 is a block diagram depicting an example of schematic configuration of a vehicle control system.
Fig. 16 is a diagram of assistance in explaining an example of installation positions of an outside-vehicle information detecting section and an imaging section.

### MODE FOR CARRYING OUT THE INVENTION

Modes for carrying out the present technology (hereinafter, referred to as embodiments) will be described below.

### <Configuration of Electronic Device>

The present technology can be applied to, for example, an electronic device such as a digital camera. Here, a case where the present technology is applied to a digital camera will be described as an example.

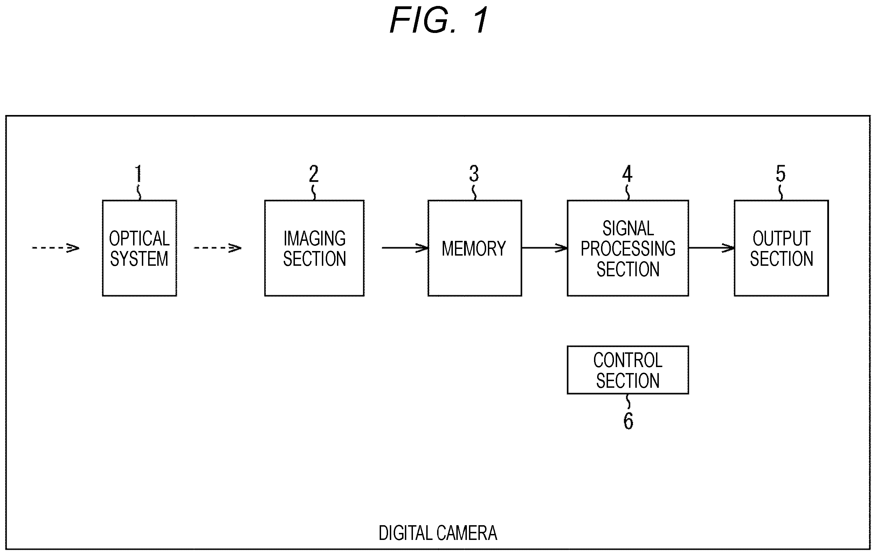

Fig. 1 is a block diagram illustrating a configuration example of an embodiment of a digital camera to which the present technology is applied. Note that the digital camera can capture both still images and moving images.

In Fig. 1, the digital camera includes an optical system 1, an imaging section 2, a memory 3, a signal processing section 4, an output section 5, and a control section 6.

The optical system 1 includes, for example, a zoom lens, a focusing lens, a diaphragm, and the like (not illustrated), and causes light from the outside to enter the imaging section 2. The imaging section 2 is, for example, a complementary metal oxide semiconductor (CMOS) image sensor, and functions as an imaging device that receives incident light from the optical system 1, performs photoelectric conversion, and outputs image data corresponding to the incident light from the optical system 1.

The memory 3 temporarily stores image data output from the imaging section 2. The signal processing section 4 performs processing such as noise removal and white balance adjustment, for example, as signal processing using the image data stored in the memory 3, and supplies the processed image data to the output section 5. The output section 5 outputs the image data from the signal processing section 4.

The output section 5 includes, for example, a display (not illustrated) constituted of liquid crystal or the like, and displays an image corresponding to the image data from the signal processing section 4 as a so-called through image. The output section 5 includes, for example, a driver (not illustrated) that drives a recording medium such as a semiconductor memory, a magnetic disk, or an optical disk, and records the image data from the signal processing section 4 on the recording medium.

The control section 6 controls each block constituting the digital camera according to a user's operation or the like.

In the digital camera configured as described above, the imaging section 2 receives incident light from the optical system 1 and outputs image data according to the incident light.

The image data output from the imaging section 2 is supplied to and stored in the memory 3. The image data stored in the memory 3 is subjected to signal processing by the signal processing section 4, and the image data obtained as a result is supplied to the output section 5 and output.

### <Configuration Example of Imaging Section>

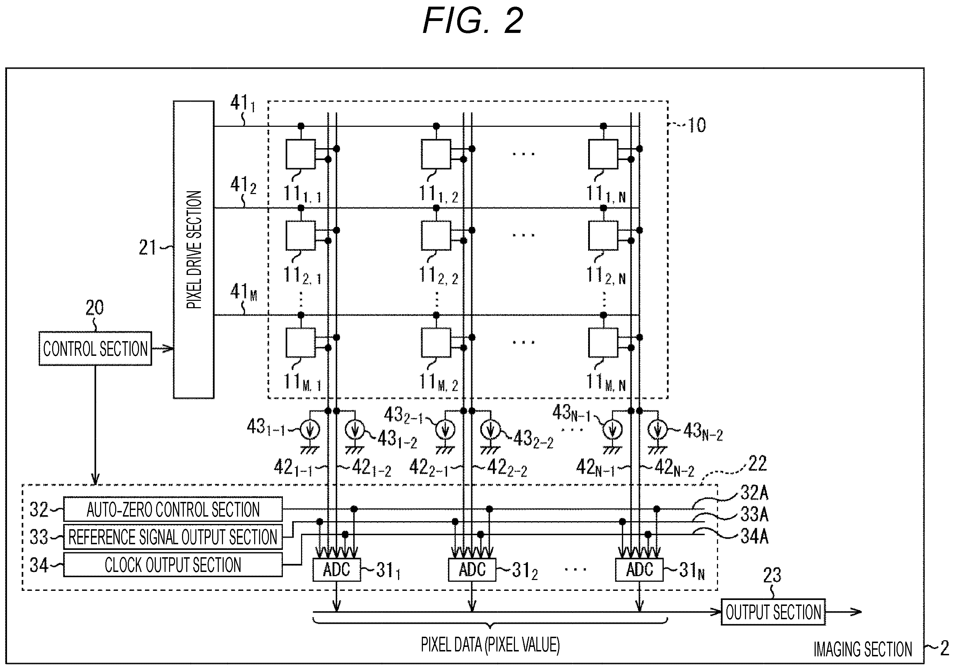

Fig. 2 is a block diagram illustrating a configuration example of the imaging section 2 in Fig. 1. In Fig. 2, the imaging section 2 includes a pixel array 10, a control section 20, a pixel drive section 21, a column-parallel AD conversion device 22, and an output section 23.

The pixel array 10 includes M × N (M and N are integers of 1 or more) pixels 11_{1,1}, 11_{1,2}, ..., 11_{1,M}, 11_{2,1}, 11_{2,2}, ..., 11_{2,N}, ..., 11_{M,1}, 11_{M,2}, ..., 11_{M,N} that perform photoelectric conversion, and functions as an imaging section (imaging element) that captures an image. The M × N pixels 11_{1,1} to 11_{M,N} are arranged in a matrix (lattice) of M rows and N columns on a two-dimensional plane.

Pixel control lines 41m extending in the row direction are connected to N pixels 11_{m,1} to 11_{m,n} arranged in the row direction (lateral direction) of the m-th row (m = 1, 2, ..., M) (from the top) of the pixel array 10.

Furthermore, M pixels 11_{1,n} to 11_{M,n} arranged in the column direction (vertical direction) of the n-th column (n = 1, 2, ..., N) (from the left) are connected with vertical signal lines (VSLs) 42n extending in the column direction. In addition to the pixels 11_{1,n} to 11_{M,n}, current sources 43n are connected to the VSLs 42n. Two VSLs 42n are provided per column. For example, the VSL 42₁₋₁ and the VSL 42₁₋₂ are provided in columns of the pixels 11_{1,1} to 11_{M,1}. As will be described later, the VSL 42₁₋₁ and the VSL 42₁₋₂ are provided for reading the reset level and reading the signal level, respectively.

The pixel 11m,n performs photoelectric conversion of light (incident light) incident thereon. Moreover, the pixel 11m,n outputs a voltage (electric signal) corresponding to the charge obtained by photoelectric conversion onto the VSL 42n under the control of the pixel drive section 21 via the pixel control line 41m.

Note that the pixel 11m,n can perform photoelectric conversion of light of a predetermined color incident via a color filter (not illustrated) in a Bayer arrangement or the like, for example.

The control section 20 controls the pixel drive section 21, (an auto-zero control section 32, a reference signal output section 33, and the like that configure) the column-parallel AD conversion device 22, and other necessary blocks according to predetermined logic or the like.

The pixel drive section 21 controls (drives) the pixels 11m,1 to 11m,N connected to the pixel control line 41m via the pixel control line 41m under the control of the control section 20.

The column-parallel AD conversion device 22 is connected to each of the pixels 11m,1 to 11m,N arranged in each row via the VSLs 42₁ to 42_{N}, and thus, an electric signal (voltage) (hereinafter, also referred to as a VSL signal) output from the pixel 11m,n onto the VSL 42n is supplied to the column-parallel AD conversion device 22.

The column-parallel AD conversion device 22 is a column-parallel AD conversion device that performs AD conversion of the VSL signals supplied from each of the pixels 11m,1 to 11m,N arranged in one row via the VSLs 42₁ to 42_{N} in parallel, and supplies digital data obtained as a result of the AD conversion to the output section 23 as pixel values (pixel data) of the pixels 11m,1 to 11m,N.

Here, the column-parallel AD conversion device 22 can perform AD conversion on the electrical signals of all the N pixels 11m,1 to 11m,N arranged in one row in parallel, and can also perform AD conversion on the electrical signals of one or more pixels less than N among the N pixels 11m,1 to 11m,N in parallel.

However, in the following description, in order to simplify the description, the column-parallel AD conversion device 22 performs AD conversion of the VSL signals of all the N pixels 11m,1 to 11m,N arranged in one row in parallel.

The column-parallel AD conversion device 22 includes N analog to digital converters (ADCs) 31₁ to 31_{N} in order to perform AD conversion of the VSL signals of all the N pixels 11m,1 to 11m,N arranged in one row in parallel.

Moreover, the column-parallel AD conversion device 22 further includes an auto-zero control section 32, a reference signal output section 33, and a clock output section 34.

The auto-zero control section 32 supplies (outputs) an AZ pulse (auto-zero pulse), which is a signal for controlling auto-zero processing of a difference comparator (to be described later) included in the ADC 31n, to the ADCs 31₁ to 31_{N} via an auto-zero control line 32A.

The reference signal output section 33 includes, for example, a digital to analog converter (DAC), and supplies (outputs) a reference signal having a period in which a level (voltage) changes from a predetermined initial value to a predetermined final value with a constant slope such as a ramp signal to the ADCs 31₁ to 31_{N} via a reference signal line 33A.

The clock output section 34 supplies (outputs) a clock of a predetermined frequency to the ADCs 31₁ to 31_{N} via a clock line 34A.

The ADC 31n is connected to the VSL 41n, and thus, the ADC 31n is supplied with the VSL signal (electrical signal) output from the pixel 11m,n onto the VSL 41n.

The ADC 31n performs AD conversion of the VSL signal output from the pixel 11m,n by using the reference signal from the reference signal output section 33 and the clock from the clock output section 34, and further performs correlated double sampling (CDS) to obtain digital data as a pixel value.

Here, the ADC 31n compares the VSL signal of the pixel 11m,n with the reference signal from the reference signal output section 33, and counts the time required for changing the level of the reference signal until the level of the VSL signal of the pixel 11m,n matches with the level of the reference signal (until the magnitude relationship between the VSL signal and the reference signal is reversed), thereby performing AD conversion of the VSL signal of the pixel 11m,n.

In the ADC 31n, the time required for the level of the reference signal to change until the level of the VSL signal of the pixel 11m,n matches the level of the reference signal is counted by counting the clock from the clock output section 34.

Furthermore, to the N ADCs 31₁ to 31_{N}, the VSL signals of the N pixels 11m,1 to 11m,N in each of the first to M-th rows of the pixel array 10 are sequentially supplied from the first row, for example, and AD conversion and CDS of the VSL signals are performed row by row.

The output section 23 selects a column n from which a pixel value is read, reads a result of AD conversion (and CDS) of the pixel 11m,n obtained by the ADC 31n from the ADC 31n of the column n as a pixel value, and outputs the result to the outside (in the present embodiment, the memory 3 (Fig. 1)).

Note that, here, the ADC 31n performs CDS in addition to AD conversion, but the ADC 31n can perform only AD conversion and CDS can be performed by the output section 23. Hereinafter, description of CDS will be omitted as appropriate.

### <Configuration Example of Imaging Section>

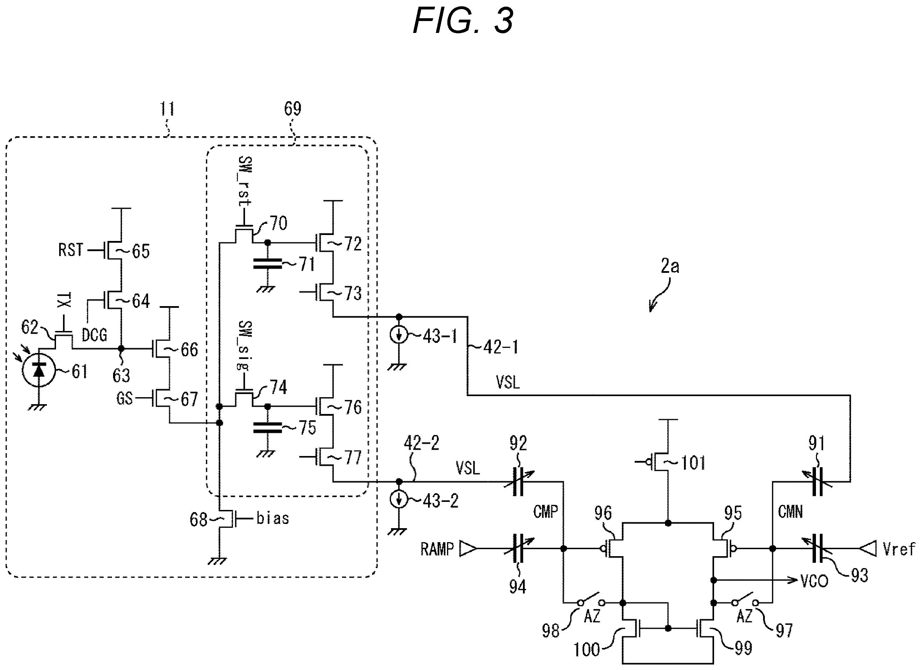

Fig. 3 is a circuit diagram of the imaging section 2, and is a circuit diagram illustrating a configuration example of a part of the pixel 11m,n (hereinafter, described as the pixel 11) and the column-parallel AD conversion device 22 in Fig. 2. The configuration of the imaging section 2 illustrated in Fig. 3 will be described as the configuration of the imaging section 2 in the first embodiment.

In Fig. 3, the pixel 11 of the pixel array 10 includes a photodiode (PD) 61, a transfer transistor 62, a floating diffusion (FD) 63, a conversion efficiency changeover switch 64, an FD reset transistor 65, an intra-pixel amplification transistor 66, a GS transistor 67, and a constant current source 68.

The pixel 11 also includes a memory section 69 that temporarily stores a reset level and a signal level in order to implement a so-called global shutter that collectively resets and collectively exposes each pixel at the same timing. The memory section 69 includes a first switch 70, a first capacitor 71, a first amplification transistor 72, a first selection transistor 73, a second switch 74, a second capacitor 75, a second amplification transistor 76, and a second selection transistor 77.

The PD 61 is, for example, a photoelectric conversion element including a PN-junction photodiode, receives light from a subject, generates a charge corresponding to the received light amount by photoelectric conversion, and accumulates the charge.

The transfer transistor 62 is provided between the PD 61 and the FD 63, and transfers the charge accumulated in the PD 61 to the FD 63 according to a drive signal TX applied to a gate electrode of the transfer transistor 62.

In Fig. 3, the transfer transistor 62, the conversion efficiency changeover switch 64, the FD reset transistor 65, and the GS transistor 67 include N-channel MOS transistors.

Drive signals TX, DCG, RST, and GS are supplied to the gate electrodes of the transfer transistor 62 to GS transistor 67. These drive signals are pulse signals in which a high-level state is an active state (on state) and a low-level state is an inactive state (off state).

Therefore, for example, in the transfer transistor 62, the charge accumulated in the PD 61 is transferred to the FD 63 when the drive signal TX supplied to the gate electrode of the transfer transistor 62 enters the active state and the transfer transistor 62 enters the on state.

The FD 63 is a floating diffusion region (FD) that converts the charge transferred from the PD 61 via the transfer transistor 62 into an electric signal, for example, a voltage signal and outputs the electric signal.

The FD reset transistor 65 is connected to the FD 63, and the memory section 69 is also connected to the FD 63 via the intra-pixel amplification transistor 66 and the GS transistor 67. Furthermore, a charge storage section (not illustrated) which is a capacitor for storing a charge is also connected to the FD 63 via a conversion efficiency changeover switch 64.

The conversion efficiency changeover switch 64 is turned on and off in response to the drive signal DCG to switch the connection state between the FD 63 and the charge storage section to either the electrically connected state or the electrically disconnected state.

That is, the drive signal DCG is supplied to the gate electrode constituting the conversion efficiency changeover switch 64, and when the drive signal DCG is turned on, the potential directly below the conversion efficiency changeover switch 64 becomes deep, and the FD 63 and the charge storage section are electrically connected.

On the other hand, when the drive signal DCG is turned off, the potential directly below the conversion efficiency changeover switch 64 becomes shallow, and the FD 63 and the charge storage section are electrically disconnected from each other. Therefore, by turning on and off the drive signal DCG, a capacitor can be added to the FD 63, and the sensitivity of the pixel can be changed.

The FD reset transistor 65 is an element that appropriately initializes (resets) each region from the FD 63 to the charge storage section, and has a drain connected to a power supply of a power supply voltage VDD and a source connected to the FD 63. The drive signal RST is applied as a reset signal to a gate electrode of the FD reset transistor 65.

Furthermore, when the drive signal RST is set to the active state, the FD reset transistor 65 is brought into a conductive state, and the potential of the FD 63 or the like is reset to the level of the power supply voltage VDD. That is, the FD 63 and the like are initialized.

The intra-pixel amplification transistor 66 has a gate electrode connected to the FD 63 and a drain connected to the power supply of the power supply voltage VDD, and serves as an input section of a source follower circuit that reads electric charge obtained by photoelectric conversion in the PD 61. That is, the source of the intra-pixel amplification transistor 66 is connected to the wiring via the GS transistor 67, thereby constituting a source follower circuit with the constant current source 68 connected to one end of the wiring.

The GS transistor 67 is connected between the source of the intra-pixel amplification transistor 66 and the wiring connecting the memory section 69 at the subsequent stage, and the drive signal GS for performing the shutter operation of the global shutter is supplied to the gate electrode of the GS transistor 67. When the drive signal GS is set to the active state, the GS transistor 67 is brought into a conductive state, and a signal from the intra-pixel amplification transistor 66 is output to the memory section 69 in the subsequent stage.

Among the signals output from the intra-pixel amplification transistor 66, the reset level signal is held in the first capacitor 71 via the first switch 70. The reset level signal accumulated in the first capacitor 71 is amplified by the first amplification transistor 72, and is output to the readout circuit in the extra-pixel region via the VLS 42-1 when the first selection transistor 73 is selected. The VSL 42-1 is a VSL corresponding to the VLS 42 in Fig. 2.

Among the signals output from the intra-pixel amplification transistor 66, the signal level signal is held in the second capacitor 75 via the second switch 74. The signal level signal accumulated in the second capacitor 75 is amplified by the second amplification transistor 76, and is output to the readout circuit in the extra-pixel region via the VLS 42-2 when the second selection transistor 77 is selected. The VSL 42-2 is a VSL corresponding to the VLS 42 in Fig. 2.

The readout circuit in the extra-pixel region is a column-parallel AD conversion device 22, and Fig. 3 illustrates a case where the readout circuit is configured by a differential comparator of the column-parallel AD conversion device 22. The readout circuit includes a constant current source 43-1 connected to the VLS 42-1, a constant current source 43-2 connected to the VSL 42-2, a capacitor 91 of the VLS 42-1, a capacitor 92 provided in the VLS 42-2, and a differential comparator.

The differential comparator includes a capacitor 93, a capacitor 94, a PMOS 95, a PMOS 96, an AZ switch 97, an AZ switch 98, an NMOS 99, an NMOS 100, and a PMOS 101. The PMOS 95 and the PMOS 96 constitute a so-called differential pair, and their sources are connected to each other. The connection point between the sources of the PMOS 95 and the PMOS 96 is connected to the drain of the PMOS 101. The PMOS 101 functions as a constant current source.

A constant voltage signal Vref is input to the gate of the PMOS 95 via the capacitor 93, and a reset level signal is input to the gate of the PMOS 95 via the capacitor 91. A gate of the PMOS 96 is connected so that a reference signal RAMP is input via the capacitor 94 and a signal level signal is input via the capacitor 92.

The differential comparator has a differential pair including the PMOS 95 and the PMOS 96 at an input stage, and the capacitor 93 and the capacitor 94 are respectively provided at gates of the PMOS 95 and the PMOS 96 as input stages of the differential pair.

The NMOS 99 and the NMOS 100 constitute a current mirror, and function as an active load of the differential pair including the PMOS 95 and the PMOS 96. In the NMOS 99 and the NMOS 100, gates and sources are connected to each other. The connection point between the gates of the NMOS 99 and the NMOS 100 is connected to the drain of the NMOS 98.

The drain of the NMOS 99 constituting the current mirror is connected to the drain of the PMOS 95, and the drain of the NMOS 100 is connected to the drain of the PMOS 96. A connection point between the PMOS 95 and the NMOS 99 is connected to an output terminal that outputs an output signal.

The AZ switch 97 and the AZ switch 98 are, for example, switches including a field effect transistor (FET) or the like, and are turned on or off according to an auto-zero pulse supplied from the auto-zero control section 32.

That is, the AZ switch 97 is turned on or off to connect or disconnect between the gate and the drain of the PMOS 95 in response to the auto-zero pulse. The AZ switch 98 is turned on or off to connect or disconnect between the gate and the drain of the PMOS 96 in response to the auto-zero pulse.

The AZ switch 97 and the AZ switch 98 are turned on in an auto-zero operation. When the AZ switch 97 and the AZ switch 98 are turned on, the capacitor 94 and the capacitor 93 are charged so that gate voltages and drain voltages of the PMOS 95 and the PMOS 96 become equal to each other. Therefore, according to the auto-zero operation, the voltage of the RAMP signal supplied to the gate of the PMOS 96 via the capacitor 94 and the voltage of the Vref signal supplied to the gate of the PMOS 95 via the capacitor 93 become the same. The voltages of the RAMP signal and the Vref signal which become equal to each other by the auto-zero operation are auto-zero potentials which are operating point potentials of the differential comparators.

The drain of the PMOS 101 is connected to a connection point between the sources of the PMOS 95 and the PMOS 96 constituting the differential pair. The PMOS 101 is used as a constant current source.

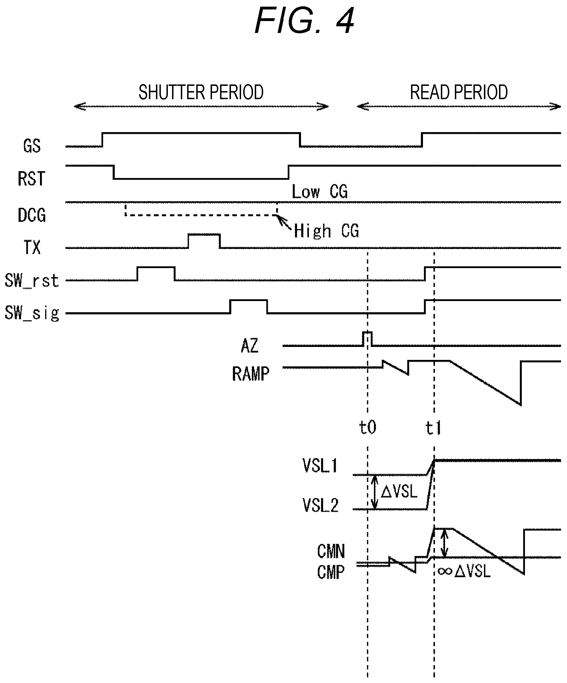

The operation of the imaging section 2 illustrated in Fig. 3 will be described with reference to Fig. 4.

As a period of the operation related to the pixel 11, a shutter period and a read period are provided. Suppose that the shutter period is a period in which a global shutter operation is performed, and is a period in which a signal of light received by the PD 61 is stored in the memory section 69. Suppose that the read period is a period in which a pixel signal is obtained by reading a signal from the memory section 69 and performing processing of the ADC 31 and the like.

When the drive signal GS supplied to the gate of the GS transistor 67 changes from an inactive state (hereinafter, described as Lo: Low) to an active state (hereinafter, described as Hi: High), the intra-pixel amplification transistor 66 enters a state of operating as a source follower. When the drive signal RST supplied to the gate of the FD reset transistor 65 changes from Hi to Lo, the reset potential of the FD 63 is determined.

In this state, when the drive signal SW_ret supplied to the gate of the first switch 70 changes from Lo to Hi, the output voltage of the intra-pixel amplification transistor 66 is transferred to and held in the first capacitor 71 via the first switch 70. That is, the signal of the reset level is held in the first capacitor 71.

When the drive signal TX supplied to the gate of the transfer transistor 62 changes from Lo to Hi, the signal charge of the PD 61 is transferred to the FD 63, and the potential of the FD 63 changes according to the signal amount. In this state, when the drive signal SW_sig supplied to the gate of the second switch 74 changes from Lo to Hi, the output voltage of the intra-pixel amplification transistor 66 is transferred to and held in the second capacitor 75 via the second switch 74. That is, a signal at a signal level is held in the second capacitor 75.

By the above operation, the voltage V1 corresponding to the reset potential of the FD 63 is held in the first capacitor 71, and the voltage V2 corresponding to (reset potential + signal charge) of the FD 63 is held in the second capacitor 75. Therefore, if a difference between the voltage V2 and the voltage V1 is obtained, the signal charge amount can be acquired.

Next, the operation in the read period will be described. In order to simplify the description, an ideal case where there is no offset or noise in the first amplification transistor 72 and the second amplification transistor 76 will be described as an example.

The read operation is performed for each row. When the corresponding row is selected, the first amplification transistor 72 and the second amplification transistor 76 are enabled to operate as source follower circuits, and outputs voltages to the VSL 42-1 and the VSL 42-2, respectively (time t0). A difference (ΔVSL) between the voltages of the VSL 42-1 and the VSL 42-2 is subjected to AD conversion.

At time t0, in order to execute auto-zero, the auto-zero pulse is set to Hi, and the AZ switch 97 and the AZ switch 98 are closed. By executing the auto-zero, the differential comparator is initialized. That is, the potentials of the end CMN and the end CMP are substantially the same. The end CMN is an end connected to one end of the capacitor 91, and the end CMP is an end connected to one end of the capacitor 92.

By this operation, information of ΔVSL is stored in the capacitor in the comparator. That is, it is a memory that when the potential difference between the VSL 41-1 and the VSL 42-2, in other words, the potential difference between the capacitor 91 and the capacitor 92 is ΔVSL, the end CMN and the end CMP have the same potential. In such a state, in order to remove the offset of the comparator, the AD conversion operation serving as a reference is performed and held as a reference level.

Subsequently, each of the drive signals GS, RST, SW_rst, and SW_sig is set to Hi. By setting these drive signals to Hi, the potential of the FD 63 is fixed to the potential VDD, and the voltage is written to the first capacitor 71 and the second capacitor 75 and output to the VSL 41-1 (capacitor 91) and the VSL 42-2 (capacitor 92) (time t1). At this time, since the potentials of the first capacitor 71 and the second capacitor 75 are the same, the potentials of the VSLs 42-1 and 42-2 are also the same.

In such a case, a potential corresponding to ΔVSL is generated in the differential comparator. That is, since the information that the difference between the VSL 42-1 and the VSL 42-2 is ΔVSL when the end CMP and the end CMN are at the same potential is stored in the capacitor in the differential comparator, when the potentials of the VSL 42-1 and the VSL 42-2 become the same at time t1, a potential difference corresponding to the ΔVSL is generated between the end CMP and the end CMN on the contrary. Therefore, the potential difference between the end CMP and the end CMN may be subjected to AD conversion.

As the voltage of the RAMP signal connected to the end CMP gradually decreases, the potential of the end CMP also decreases accordingly. By counting the time until the end CMP and the end CMN become the same potential and the comparator is inverted, it is possible to detect how much the potential difference between the end CMP and the end CMN was, that is, how much ΔVSL was, that is, how much (voltage V2 - voltage V1) was, and it is possible to complete the AD conversion operation of the signal level. Then, the offset of the differential comparator can be removed by calculating the difference from the previous reference level AD conversion result.

With such an operation, AD conversion of a signal level (V2 - V1) desired to be detected can be executed.

Next, a case where offset or low-frequency noise occurs in the first amplification transistor 72 and the second amplification transistor 76 will be described. Ideally, at time 0, the potential difference ΔVSL between the VSL 42-1 and the VSL 2-2 becomes a potential difference (V2 - V1) between the first capacitor 71 and the second capacitor 75. However, in a case where an offset or low-frequency noise occurs in the transistor, the voltage Vofs corresponding thereto is also added, and there is a possibility that a potential difference ((V2 - V1) + Vofs) is generated.

At time t1, since the voltages of the first capacitor 71 and the second capacitor 75 are exactly the same, the potential difference between the VSL 42-1 and the VSL 42-2 appearing here is only the voltage Vofs.

The AD conversion operation in the present embodiment uses a method in which a difference between the state of the potential of the VSL 42 at time t1 and the state of the potential of the VSL 42 at time t0 is a result of the AD conversion. Then, the voltage Vofs is canceled, and the signal level (V2 - V1) desired to be detected can be detected.

Even in a case where uncorrelated low-frequency noise occurs in the first amplification transistor 72 and the second amplification transistor 76, since the differential comparator is initialized (auto-zero) at time t0, only a noise component that fluctuates in the period from time t0 to time t1 appears in the result of AD conversion. That is, the noise having a cycle longer than the period between the time t0 and the time t1 is canceled by the auto-zero processing similarly to the fixed offset described above.

As described above, the signal level (V2 - V1) desired to be detected can be AD-converted without being affected by the offset variation and the low-frequency noise generated in the first amplification transistor 72 and the second amplification transistor 76, and a good image can be obtained.

### <Imaging Section Having Stacked Structure>

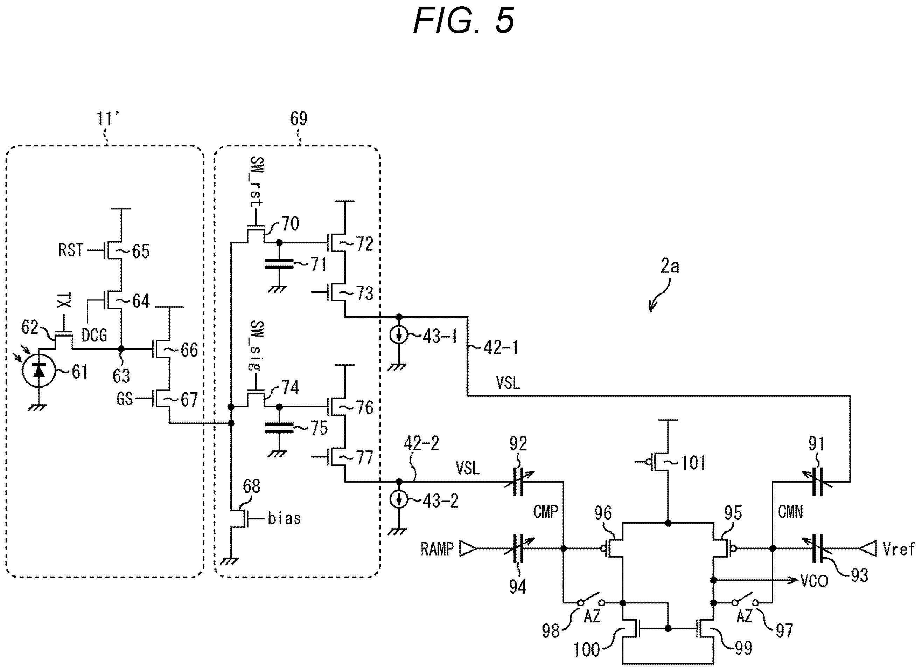

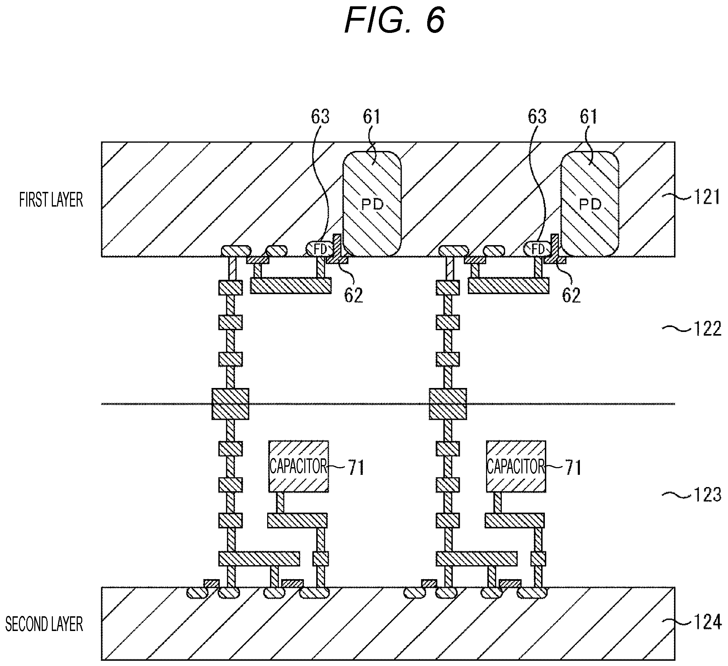

An imaging section 2a can be an imaging section having a stacked structure. A configuration in a case where the imaging section 2a has a stacked structure will be described with reference to Figs. 5 and 6. A configuration related to the pixel 11 of the imaging section 2a will be described by taking a case of a configuration similar to that in Fig. 3 as an example, and is illustrated in Fig. 5 again. In a case where the imaging section 2a has a stacked structure, the pixel 11 can be divided into the memory section 69 and the other portion.

The pixel 11 is divided into a pixel 11' and a memory section 69. The pixel 11' is a portion including the PD 61 in the pixel 11 (Fig. 3), and the pixel 11' can be provided in the first layer as illustrated in Fig. 6. The memory section 69 can be provided in the second layer as illustrated in Fig. 6. Fig. 6 is a diagram illustrating a cross-sectional configuration example of the pixel 11, and illustrates two pixels.

In a substrate 121 of the first layer, the PD 61 included in the pixel 11', a part constituting the transfer transistor 62, the FD 73, and the like are formed. A wiring layer 122 is stacked on the substrate 121 of the first layer. A plurality of wirings is formed in the wiring layer 122, and some of the wirings are connected to the first capacitor 71 or the like formed in a substrate 124 of the second layer via a wiring layer 123.

In the example illustrated in Fig. 6, the first capacitor 71 is formed in the wiring layer 123. Although not illustrated in Fig. 6, the second capacitor 75 is also formed in the wiring layer 123. As illustrated in Fig. 5, the constant current source 68 may be formed in the second layer.

Circuits related to reading, for example, a difference comparator or the like may be arranged in the second layer, or may be arranged in another stacked layer, for example, the first layer or the third layer (not illustrated), according to the invention.

With such a stacked structure, the area of the PD 61 can be maximized in the first layer of the pixel 11, and sensitivity and saturation characteristics can be improved. In the second layer of the pixel 11, the first capacitor 71 and the second capacitor 75 can be maximized, and for example, it is possible to suppress the occurrence of KTC noise that is likely to occur when a small capacitor and a switch are connected.

In this manner, the imaging section 2 to which the present technology is applied can have a stacked structure. The stacked structure can also be applied to the embodiments described below.

### <Configuration and Operation of Imaging Device in Second Embodiment>

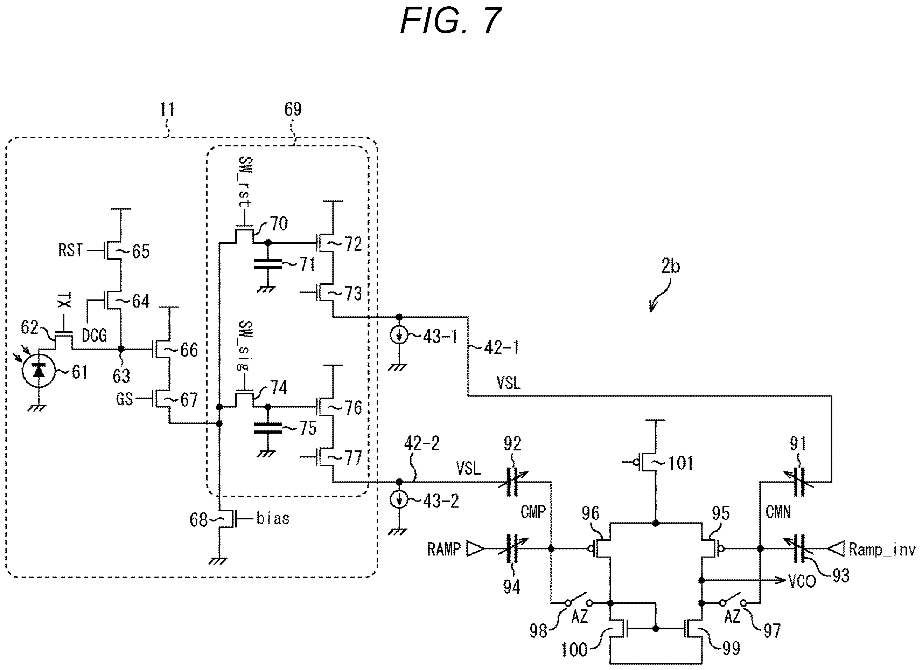

Fig. 7 is a diagram illustrating a configuration example of an imaging section 2b in the second embodiment. The basic configuration of the imaging section 2b illustrated in Fig. 7 is similar to that of the imaging section 2a illustrated in Fig. 3. Other points are similar, except that the constant voltage Vref connected to one input terminal CMN of the differential comparator constituting the imaging section 2a illustrated in Fig. 3 is an inverted ramp signal (signal RAMP _inv) in which the ramp signal is inverted in the imaging section 2b illustrated in Fig. 7.

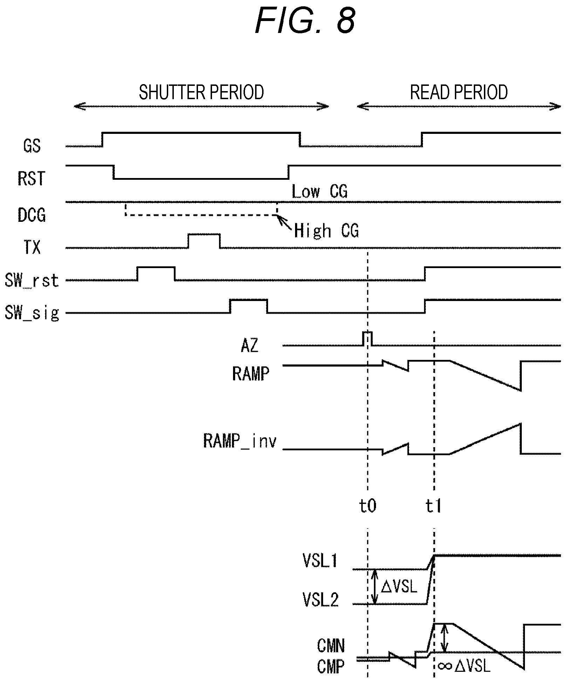

The operation of the imaging section 2b illustrated in Fig. 7 will be described with reference to Fig. 8. Since the operation in the shutter period is similar to the operation of the imaging section 2a in the first embodiment described with reference to Figs. 3 and 4, the description thereof will be omitted here. The operation in the read period is basically similar, but is different in that the reference signal RAMP_inv obtained by inverting the polarity of the reference signal PAMP is input to the gate side of the PMOS 95.

Even in a case where the signal supplied to the PMOS 95 is the reference signal RAMP_inv, the voltage level according to the potential difference ΔVSL can be AD-converted as in the first embodiment, and a similar effect can be obtained.

In the imaging section 2b in the second embodiment, even if the amplitude of the reference signal RAMP is about half the amplitude of the reference signal RAMP of the imaging section 2a in the first embodiment, AD conversion can be performed with the same accuracy as in the first embodiment. Since the reference signal RAMP_inv having the opposite phase to the reference signal RAMP is input to the differential comparator described with reference to Figs. 7 and 8, the amplitude of the ΔVSL same as that of the imaging section 2a of the first embodiment can be AD-converted even if the amplitude of the reference signal RAMP is reduced.

According to the imaging section 2a in the second embodiment, it is possible to reduce the voltage of the reference signal output section 33 (Fig. 2) that generates the reference signal RAMP.

Even in a case where in-phase noise is superimposed on the reference signal RAMP and the reference signal RAMP_inv having the opposite phase, noise can be canceled by the operation of the differential comparator, and thus AD conversion can be performed with high accuracy.

### <Configuration of Imaging Device in Third Embodiment>

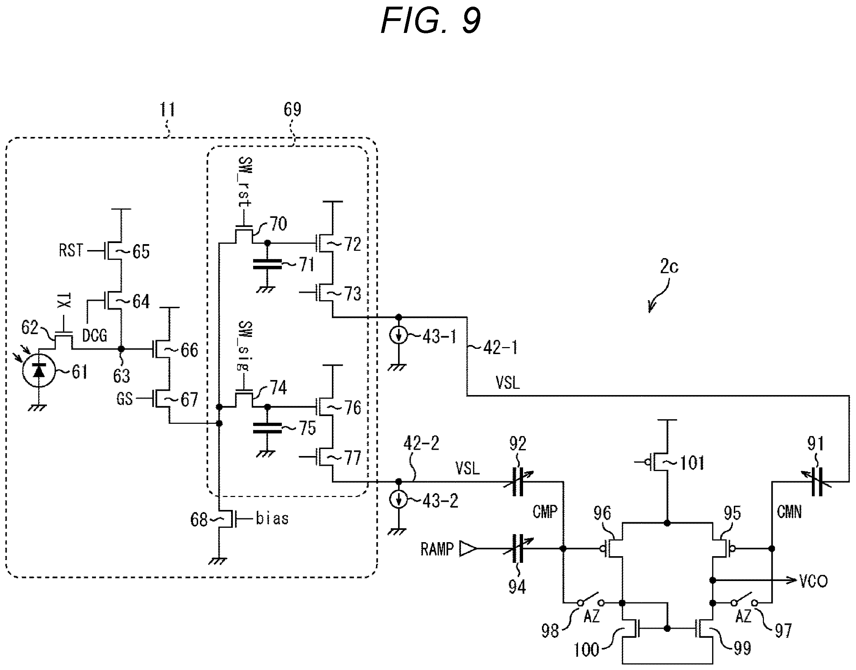

Fig. 9 is a diagram illustrating a configuration example of an imaging section 2c in the third embodiment. The basic configuration of the imaging section 2c illustrated in Fig. 9 is similar to that of the imaging section 2a in the first embodiment illustrated in Fig. 3. The imaging section 2c illustrated in Fig. 9 has a configuration in which the constant voltage Vref and the capacitor 93 connected to one input terminal CMN of the differential comparator constituting the imaging section 2a illustrated in Fig. 3 are deleted, but the other points are similar.

For the differential comparators of the imaging sections 2a and 2b in the first embodiment and the second embodiment, examples in which the configurations of the two input terminals are made uniform in order to ensure differential pairing (symmetry) are illustrated. Since the AD conversion operation can be performed even if symmetry is not ensured, a configuration in which the constant voltage Vref and the capacitor 93 are not connected to the input terminal CMN as illustrated in Fig. 9 can be adopted.

The operation of the imaging section 2c in the third embodiment is similar to the operation of the imaging section 2a in the first embodiment, in other words, similar to the operation described with reference to Fig. 4, and thus the description thereof is omitted here.

Also in the imaging section 2c having the configuration illustrated in Fig. 9, the AD conversion operation can be normally performed, and the AD conversion operation in which the offset and noise of the first amplification transistor 72 and the second amplification transistor 76 are removed can be performed.

### <Configuration and Operation of Imaging Device in Fourth Embodiment>

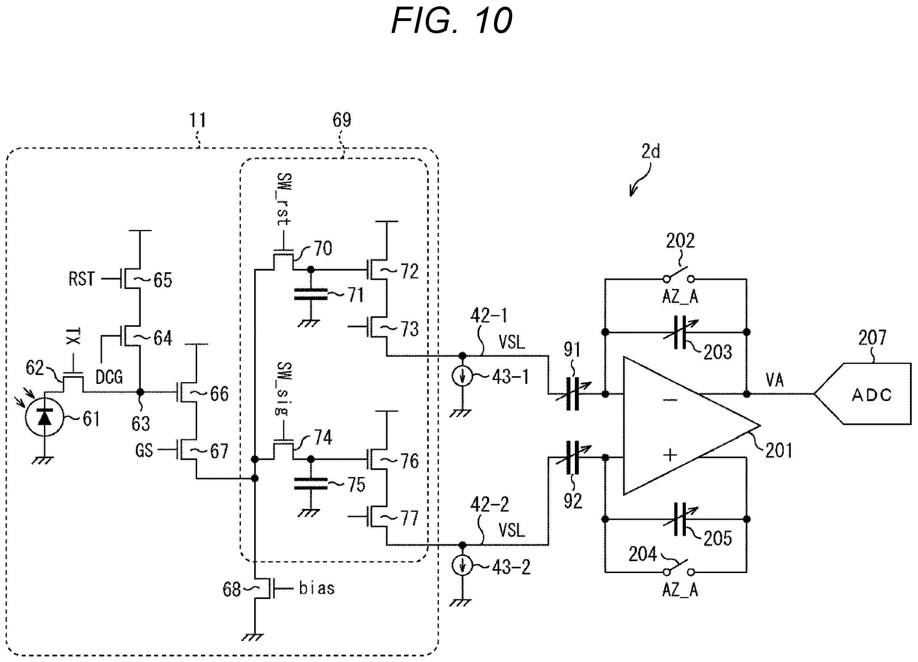

Fig. 10 is a diagram illustrating a configuration example of an imaging section 2d in the fourth embodiment. The basic configuration of the imaging section 2d illustrated in Fig. 10 is similar to that of the imaging section 2a in the first embodiment illustrated in Fig. 3. The imaging section 2d illustrated in Fig. 10 has a different configuration of the differential comparator constituting the imaging section 2a illustrated in Fig. 3, and portions related to the pixel 11 are the same.

The signal read from the pixel 11 is input to a differential amplifier 201 via the VLS 42-1 and the VLS 42-2. As in the above-described embodiment, an AZ_A switch 202, a capacitor 203, an AZ_A switch 204, and a capacitor 205 are connected to the differential amplifier 201 (provided in the differential amplifier 201) in order to initialize the voltage of the differential amplifier 201, that is, to execute the auto-zero processing. The output from the differential amplifier 201 is supplied to an analog/digital converter (ADC) 207.

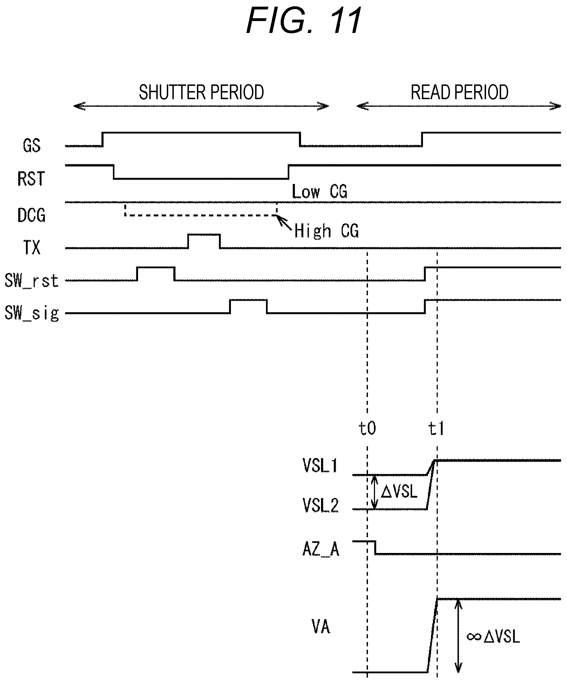

The operation of the imaging section 2d illustrated in Fig. 10 will be described with reference to Fig. 11. Since the operation in the shutter period is the same as that of the imaging section 2a in the first embodiment, the description thereof will be omitted. In the read period, the AZ_A switch 202 and the AZ_A switch 204 are closed at time t0, so that the auto-zero operation is executed.

Similarly to the first embodiment, the time t0 is a state in which the voltage ΔVSL corresponding to the signal level is generated in the VLS 42-1 and the VLS 42-2. In this state, when the auto-zero operation is executed, the differential amplifier 201 is initialized, and the potential ΔVSL is stored in the capacitor in the differential amplifier 201.

At time t1, when the voltages of the FD 63, the first capacitor 71, and the second capacitor 75 are reset and the VLS 42-1 and the VLS 42-1 become the same potential, the output VA from the differential amplifier 201 changes with an amplitude corresponding to the voltage ΔVSL. Therefore, the difference between the output VA at time t0 and the output VA at time t1 is AD-converted by the ADC 201, so that the signal level desired to be detected can be detected as in the first embodiment.

Note that the form of AD conversion in the ADC 207 is not limited as long as it can be applied to the present embodiment, and is a method capable of performing AD conversion on two voltage levels.

With the above operation, as in the first to third embodiments, it is possible to detect a signal from which offset and noise of the first amplification transistor 72 and the second amplification transistor 76 have been removed.

In the fourth embodiment, by changing the gain of the differential amplifier 201, for example, it is possible to perform adjustment such as increasing the gain in a case where the captured image is dark. Therefore, it is possible to capture a desired image with improved image quality.

### <Operation of Imaging Device in Fifth Embodiment>

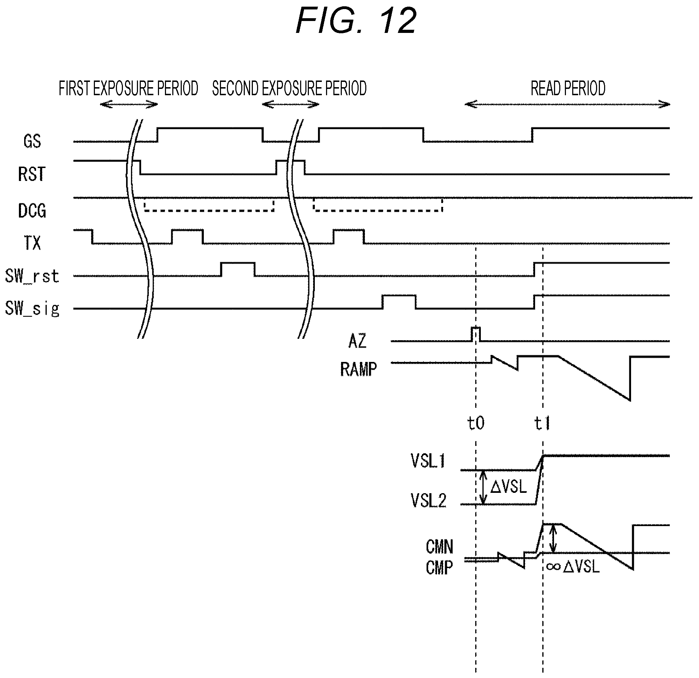

By setting the operation of the imaging section 2 in the first to fourth embodiments to an operation as will be described with reference to Fig. 12, the imaging section 2 can be used as, for example, a motion detection sensor. Here, an operation of the imaging section 2 in a case where the imaging section 2a in the first embodiment is used as a motion detection sensor will be described with reference to Fig. 12.

The imaging section 2a in the first embodiment has a role of holding the FD reset level by the first capacitor 71 and a role of holding the FD reset level + signal charge by the second capacitor 75, and is driven to obtain the signal charge amount by taking a difference therebetween.

As a fifth embodiment, a role of holding the FD reset level by the first capacitor 71 is a role of accumulating signal charges in the first exposure period, and a role of holding the FD reset level + signal charges by the second capacitor 75 is a role of accumulating signal charges in the second exposure period. The signal charge amount is obtained by taking the difference, and it is determined whether or not there is a change in the signal charge amount, thereby detecting whether or not there is motion in the subject.

Referring to Fig. 12, first, the drive signal RST and the drive signal TX are set to Hi, and the charge of the PD 61 is emptied. When the charge of the PD 61 is emptied, the drive signal RST and the drive signal TX are returned to Lo, and the first exposure period is started.

After the first exposure period ends, the drive signal TX is set to Hi, and the signal charge is transferred from the PD 61 to the FD 63. In this state, when the drive signal SW_RST is set to Hi, the first switch 70 is turned on, and a voltage corresponding to the signal charge during the first exposure period is written to the first capacitor 71.

When the FD 63 is reset again by setting the drive signal RST to Hi, the drive signal RST is returned to Lo, and the second exposure period is started. The first exposure period and the second exposure period are periods having the same length.

After the second exposure period ends, the drive signal TX is set to Hi, and the signal charge is transferred from the PD 61 to the FD 63. In this state, when the drive signal SW_sig is set to Hi, the second switch 74 is turned on, and a voltage corresponding to the signal charge during the second exposure period is written to the second capacitor 75.

In this manner, when a signal corresponding to the electric charge photoelectrically converted during the first exposure period is accumulated in the first capacitor 71 and a signal corresponding to the electric charge photoelectrically converted during the second exposure period is accumulated in the second capacitor 75, the signals accumulated in the first capacitor 71 and the second capacitor are read out. The operation related to reading is a reading operation similar to that of the imaging section 2a of the first embodiment, and the description thereof has already been made, and thus the description thereof is omitted here.

A signal corresponding to the difference ΔVSL between the signal charge in the first exposure period (referred to as first signal charge) and the signal charge in the second exposure period (referred to as second signal charge) is output from the differential comparator. In a case where the subject does not move between the start of the first exposure period and the end of the second exposure period, the first signal charge and the second signal charge become the same, and the difference ΔVSL becomes 0 (or a value falling within a predetermined range that can be regarded as 0).

On the other hand, in a case where the subject moves between the start of the first exposure period and the end of the second exposure period, the first signal charge and the second signal charge have different values, and the difference ΔVSL is other than 0 (a value outside the predetermined range). In this manner, by taking the difference between the first signal charge and the second signal charge, it is possible to detect whether or not there is motion in the subject, and the imaging section 2 can be used as the motion detection sensor.

Even in a case where the imaging section 2 is used as such a motion detection sensor, as in the embodiments described above, it is possible to cancel the offset and the low-frequency noise of the first amplification transistor 72 and the second amplification transistor 76, and it is possible to obtain a favorable signal.

According to the present technology, it is possible to cancel offset and noise of each transistor. The fixed pattern noise due to the variation in offset can be suppressed. Since low-frequency noise can also be canceled, random noise can also be suppressed.

### <Application Example to Endoscopic Surgery System>

The technology according to an embodiment of the present disclosure (present technology) can be applied to various products. For example, the technology according to an embodiment of the present disclosure may be applied to an endoscopic surgery system.

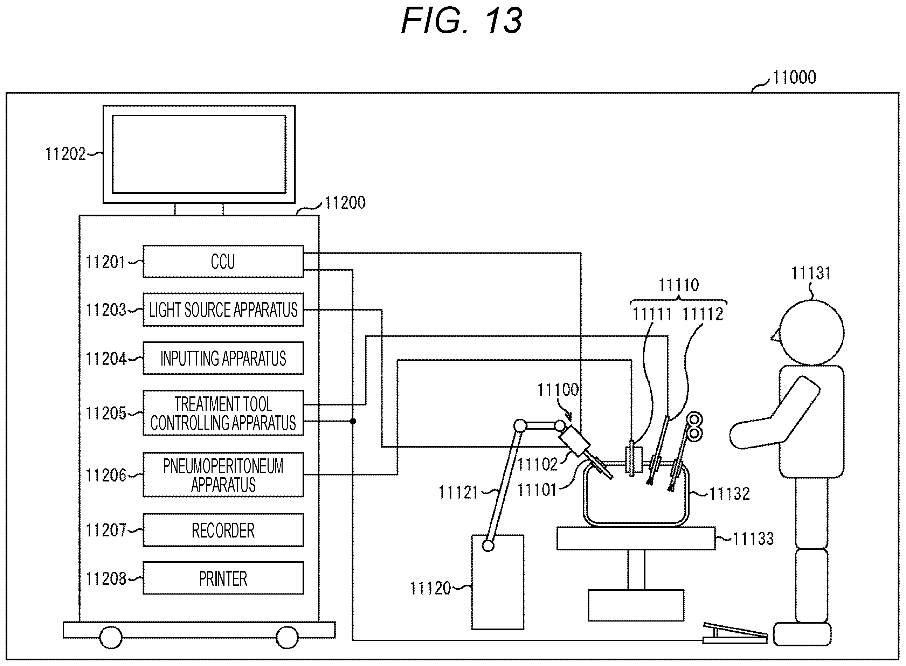

Fig. 13 is a view depicting an example of a schematic configuration of an endoscopic surgery system to which the technology according to an embodiment of the present disclosure (present technology) can be applied.

In Fig. 13, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

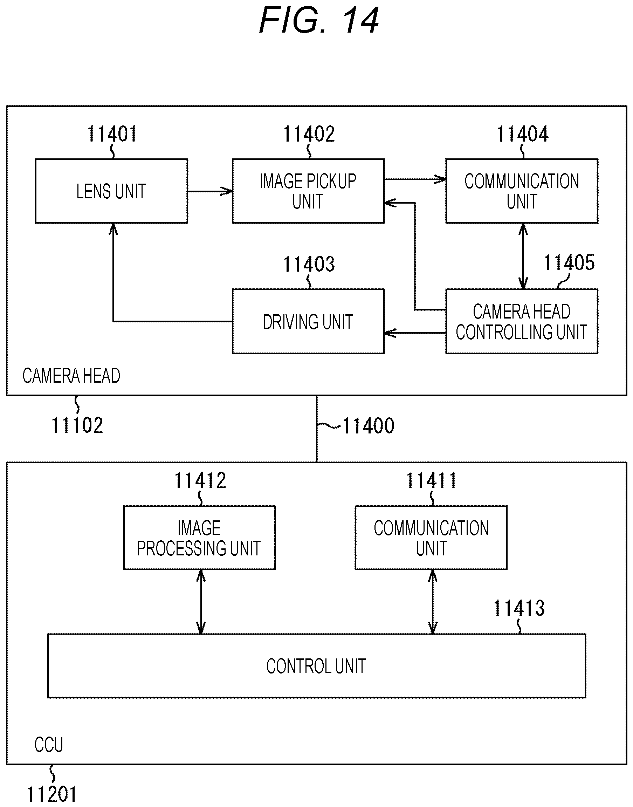

Fig. 14 is a block diagram depicting an example of a functional configuration of the camera head 11102 and the CCU 11201 depicted in Fig. 13.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

### <Application Example to Mobile Body>

The technology according to an embodiment of the present disclosure (present technology) can be applied to various products. For example, the technology according to an embodiment of the present disclosure may be implemented as a device mounted on any type of mobile body such as an automobile, an electric vehicle, a hybrid electric vehicle, a motorcycle, a bicycle, a personal mobility, an airplane, a drone, a ship, a robot, and the like.

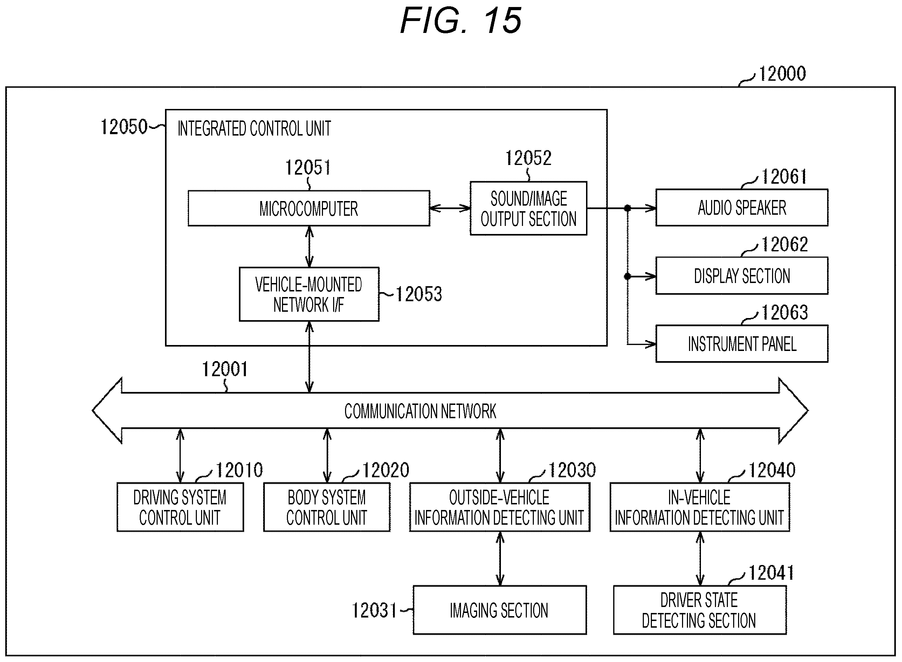

Fig. 15 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in Fig. 15, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of Fig. 15, an audio speaker 12061, a display section 12062, and an instrument panel 12063 are illustrated as the output device. The display section 12062 may, for example, include at least one of an on-board display and a head-up display.

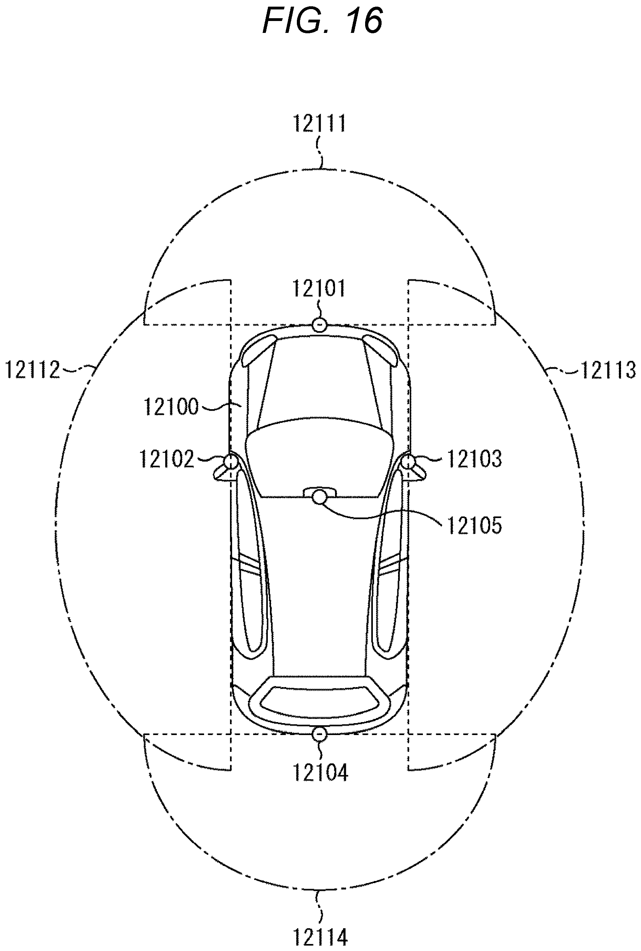

Fig. 16 is a diagram depicting an example of the installation position of the imaging section 12031.

In Fig. 16, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, Fig. 16 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

In the present specification, the system represents the entire device including a plurality of devices.

Note that the effects described in the present specification are merely examples and are not limited, and other effects may be provided.

The invention is defined by the appended claims.

### REFERENCE SIGNS LIST

- 1: Optical system
- 2: Imaging section
- 3: Memory
- 4: Signal processing section
- 5: Output section
- 6: Control section
- 10: Pixel array
- 11: Pixel
- 20: Control section
- 21: Pixel drive section
- 22: Column-parallel AD conversion device
- 23: Output section
- 27: Vertical signal line
- 32: Auto-zero control section
- 33: Reference signal output section
- 34: Clock output section
- 41: Pixel control line
- 43: Current source
- 62: Transfer transistor
- 64: Conversion efficiency changeover switch
- 65: FD reset transistor
- 66: Intra-pixel amplification transistor
- 67: GS transistor
- 68: Constant current source
- 69: Memory section
- 70: First switch
- 71: First capacitor
- 72: First amplification transistor
- 73: First selection transistor
- 74: Second switch
- 75: Second capacitor
- 76: Second amplification transistor
- 77: Second selection transistor
- 91 to 94: Capacitor
- 97, 98: AZ switch
- 121: Substrate
- 122: Wiring layer
- 123: Wiring layer
- 124: Substrate
- 201: Differential amplifier
- 202: AZ_A switch
- 203: Capacitor
- 204: AZ_A switch
- 205: Capacitor

## Claims

1. An imaging device (2, 2a, 2b, 2c, 2d) comprising:
a photoelectric conversion section (61, 62, 63, 64, 65, 66, 67, 68) configured to perform photoelectric conversion;
a first capacitor (71) configured to hold a first signal from the photoelectric conversion section (61, 62, 63, 64, 65, 66, 67, 68), the first capacitor (71) being connected to a floating diffusion, FD (63) of the photoelectric conversion section (61, 62, 63, 64, 65, 66, 67, 68) via an intra-pixel amplification transistor (66) and a global shutter,GS, transistor (67);
a second capacitor (75) configured to hold a second signal from the photoelectric conversion section (61, 62, 63, 64, 65, 66, 67, 68), the second capacitor (75) being connected to the FD (63) of the photoelectric conversion section (61, 62, 63, 64, 65, 66, 67, 68) via the intra-pixel amplification transistor (66) and the GS transistor (67);
a first reading section (43-1, 91) that reads the first signal held in the first capacitor (71), the first reading section (43-1, 91) comprising a third capacitor (91);
a second reading section (43-2, 92) that reads the second signal held in the second capacitor (75), the second reading section (43-2, 92) comprising a fourth capacitor (92);
a first amplification transistor (72) that outputs the first signal via a first vertical signal line, VSL (42-1), to the first reading section (43-1, 42-1, 91);
a second amplification transistor (76) that outputs the second signal via a second vertical signal line, VSL (42-2), to the second reading section (42-2, 43-2, 92);
a differential circuit in which the first signal from the first reading section (43-1, 91) is input at one end via the third capacitor (91) and the second signal from the second reading section is input at another end via the fourth capacitor (92);
an initialization section configured to initialize the differential circuit, the initialization section including a capacitor (99, 100, 203, 205) and a switch (97, 98, 202, 204); and wherein the photoelectric conversion section (61, 62, 63, 64, 65, 66, 67, 68) is included in a first substrate (121), the first capacitor (71) and the second capacitor (75) are included in a second substrate (124), and the differential circuit is included in a third substrate.

2. The imaging device (2, 2a, 2b, 2c, 2d) of claim 1, further comprising a first wiring layer (122) stacked on the first substrate (121), and a second wiring layer (123) stacked on the second substrate (124), wherein the first wiring layer (122) and the second wiring layer (123) are arranged to face one another.

3. The imaging device (2, 2a, 2b, 2c, 2d) of any of the preceding claims, wherein the first substrate (121) and the second substrate (124) are electrically connected through the first wiring layer (122) and the second wiring layer (123).

4. The imaging device (2, 2a, 2b, 2c, 2d) of any of the preceding claims, wherein the photoelectric conversion section (61, 62, 63, 64, 65, 66, 67, 68) includes a photodiode (61), a transfer transistor (62), the floating diffusion (63), a switch transistor (64), a floating diffusion reset transistor (65), the intra-pixel amplification transistor (66), the imaging device (2, 2a, 2b, 2c, 2d) further including a memory section (69) in the second substrate (124), the memory section (69) including a first switch transistor (70), the first capacitor (71), a first amplification transistor (72), a first selection transistor (73), a second switch transistor (74), the second capacitor (75), a second amplification transistor (76), and a second selection transistor (77).

5. The imaging device (2, 2a, 2b, 2c, 2d) according to any of the preceding claims, wherein
the first capacitor (71) holds a reset level, and
the second capacitor (75) holds a signal level.

6. The imaging device (2, 2a, 2b, 2c, 2d) according to any of the preceding claims, wherein
a ramp signal is input to the one end or the another end.

7. The imaging device (2, 2a, 2b, 2c) according to any of the preceding claims, wherein
the differential circuit is a differential comparator (93, 94, 95, 96, 101).

8. The imaging device (2, 2d) according to any of claims 1 to 6, wherein
the differential circuit includes a differential amplifier (201).

9. The imaging device (2, 2b) according to any of the preceding claims, wherein
a ramp signal is input to one of the one end and the another end, and a signal in which a polarity of the ramp signal is inverted is input to the other end.

10. The imaging device (2, 2a) according to any of claims 1 to 8, wherein
a ramp signal is input to one of the one end and the another end, and a signal of a constant voltage is input to the other end.

11. The imaging device (2, 2a, 2b, 2c, 2d) according to any of claims 1 to 4 and 6 to 10, wherein
the first capacitor (71) holds the first signal photoelectrically converted in a first exposure period, and
the second capacitor (75) holds the second signal photoelectrically converted in a second exposure period.

## Patentansprüche

1. Bildgebungsvorrichtung (2, 2a, 2b, 2c, 2d), umfassend:
einen photoelektrischen Umwandlungsabschnitt (61, 62, 63, 64, 65, 66, 67, 68), der zum Durchführen einer photoelektrischen Umwandlung konfiguriert ist;
einen ersten Kondensator (71), der konfiguriert ist, um ein erstes Signal vom photoelektrischen Umwandlungsabschnitt (61, 62, 63, 64, 65, 66, 67, 68) zu halten, wobei der erste Kondensator (71) mit einer floatenden Diffusion(FD) (63) des photoelektrischen Umwandlungsabschnitts (61, 62, 63, 64, 65, 66, 67, 68) über einen Intra-Pixel-Verstärkungstransistor (66) und einen globalen Verschlusstransistor (GS) (67) verbunden ist;
einen zweiten Kondensator (75), der konfiguriert ist, um ein zweites Signal vom photoelektrischen Umwandlungsabschnitt (61, 62, 63, 64, 65, 66, 67, 68) zu halten, wobei der zweite Kondensator (75) über den Intra-Pixel-Verstärkungstransistor (66) und den GS-Transistor (67) mit dem FD (63) des photoelektrischen Umwandlungsabschnitts (61, 62, 63, 64, 65, 66, 67, 68) verbunden ist;
einen ersten Leseabschnitt (43-1, 91), der das im ersten Kondensator (71) gehaltene erste Signal liest, wobei der erste Leseabschnitt (43-1, 91) einen dritten Kondensator (91) umfasst;
einen zweiten Leseabschnitt (43-2, 92), der das im zweiten Kondensator (75) gehaltene zweite Signal liest, wobei der zweite Leseabschnitt (43-2, 92) einen vierten Kondensator (92) umfasst;
einen ersten Verstärkungstransistor (72), der das erste Signal über eine erste vertikale Signalleitung (VSL) (42-1) an den ersten Leseabschnitt (43-1, 42-1, 91) ausgibt;
einen zweiten Verstärkungstransistor (76), der das zweite Signal über eine zweite vertikale Signalleitung (VSL) (42-2) an den zweiten Leseabschnitt (42-2, 43-2, 92) ausgibt;
eine Differentialschaltung, in die das erste Signal vom ersten Leseabschnitt (43-1, 91) an einem Ende über den dritten Kondensator (91) und das zweite Signal vom zweiten Leseabschnitt am anderen Ende über den vierten Kondensator (92) eingegeben wird;
einen Initialisierungsabschnitt, der zum Initialisieren der Differentialschaltung konfiguriert ist, wobei der Initialisierungsabschnitt einen Kondensator (99, 100, 203, 205) und einen Schalter (97, 98, 202, 204) einschließt; und wobei der photoelektrische Umwandlungsabschnitt (61, 62, 63, 64, 65, 66, 67, 68) in einem ersten Substrat (121) eingeschlossen ist, der erste Kondensator (71) und der zweite Kondensator (75) in einem zweiten Substrat (124) eingeschlossen sind und die Differentialschaltung in einem dritten Substrat eingeschlossen ist.

2. Bildgebungsvorrichtung (2, 2a, 2b, 2c, 2d) nach Anspruch 1, die ferner eine auf dem ersten Substrat (121) gestapelte erste Verdrahtungsschicht (122) und eine auf dem zweiten Substrat (124) gestapelte zweite Verdrahtungsschicht (123) umfasst, wobei die erste Verdrahtungsschicht (122) und die zweite Verdrahtungsschicht (123) so angeordnet sind, dass sie einander zugewandt sind.

3. Bildgebungsvorrichtung (2, 2a, 2b, 2c, 2d) nach einem der vorstehenden Ansprüche, wobei das erste Substrat (121) und das zweite Substrat (124) durch die erste Verdrahtungsschicht (122) und die zweite Verdrahtungsschicht (123) elektrisch verbunden sind.

4. Bildgebungsvorrichtung (2, 2a, 2b, 2c, 2d) nach einem der vorstehenden Ansprüche, wobei der photoelektrische Umwandlungsabschnitt (61, 62, 63, 64, 65, 66, 67, 68) eine Photodiode (61), einen Transfertransistor (62), die floatende Diffusion (63), einen Schalttransistor (64), einen floatende Diffusion-Rücksetztransistor (65), den Intra-Pixel-Verstärkungstransistor (66) einschließt, wobei die Bildgebungsvorrichtung (2, 2a, 2b, 2c, 2d) ferner einen Speicherabschnitt (69) im zweiten Substrat (124) einschließt, wobei der Speicherabschnitt (69) einen ersten Schalttransistor (70), den ersten Kondensator (71), einen ersten Verstärkungstransistor (72), einen ersten Auswahltransistor (73), einen zweiten Schalttransistor (74), den zweiten Kondensator (75), einen zweiten Verstärkungstransistor (76) und einen zweiten Auswahltransistor (77) einschließt.

5. Bildgebungsvorrichtung (2, 2a, 2b, 2c, 2d) nach einem der vorstehenden Ansprüche, wobei
der erste Kondensator (71) einen Rücksetzpegel hält und
der zweite Kondensator (75) einen Signalpegel hält.

6. Bildgebungsvorrichtung (2, 2a, 2b, 2c, 2d) nach einem der vorstehenden Ansprüche, wobei
ein Rampensignal an dem einen oder dem anderen Ende eingegeben wird.

7. Bildgebungsvorrichtung (2, 2a, 2b, 2c, 2d) nach einem der vorstehenden Ansprüche, wobei
die Differentialschaltung ein Differentialkomparator (93, 94, 95, 96, 101) ist.

8. Bildgebungsvorrichtung (2, 2d) nach einem der Ansprüche 1 bis 6, wobei
die Differentialschaltung einen Differenzverstärker (201) einschließt.

9. Bildgebungsvorrichtung (2, 2b) nach einem der vorstehenden Ansprüche, wobei
ein Rampensignal an einem des einen und des anderen Endes eingegeben wird, und ein Signal an dem anderen Ende eingegeben wird, bei dem eine Polarität des Rampensignals invertiert ist.

10. Bildgebungsvorrichtung (2, 2a) nach einem der Ansprüche 1 bis 8, wobei
ein Rampensignal an einem des einen und des anderen Endes eingegeben wird, und ein Signal mit konstanter Spannung an dem anderen Ende eingegeben wird.

11. Bildgebungsvorrichtung (2, 2a, 2b, 2c, 2d) nach einem der Ansprüche 1 bis 4 und 6 bis 10, wobei
der erste Kondensator (71) das in einer ersten Belichtungsperiode photoelektrisch umgewandelte erste Signal hält, und
der zweite Kondensator (75) das in einer zweiten Belichtungsperiode photoelektrisch umgewandelte zweite Signal hält.

## Revendications

1. Dispositif d'imagerie (2, 2a, 2b, 2c, 2d) comprenant :
une section de conversion photoélectrique (61, 62, 63, 64, 65, 66, 67, 68) configurée pour mettre en œuvre une conversion photoélectrique ;
un premier condensateur (71) configuré pour conserver un premier signal provenant de la section de conversion photoélectrique (61, 62, 63, 64, 65, 66, 67, 68), le premier condensateur (71) étant connecté à une diffusion flottante, FD (63) de la section de conversion photoélectrique (61, 62, 63, 64, 65, 66, 67, 68) par l'intermédiaire d'un transistor d'amplification intra-pixel (66) et d'un transistor obturateur global, GS (67) ;
un deuxième condensateur (75) configuré pour conserver un second signal provenant de la section de conversion photoélectrique (61, 62, 63, 64, 65, 66, 67, 68), le deuxième condensateur (75) étant connecté à la FD (63) de la section de conversion photoélectrique (61, 62, 63, 64, 65, 66, 67, 68) par l'intermédiaire du transistor d'amplification intra-pixel (66) et du transistor GS (67) ;
une première section de lecture (43-1, 91) qui lit le premier signal conservé dans le premier condensateur (71), la première section de lecture (43-1, 91) comprenant un troisième condensateur (91) ;
une seconde section de lecture (43-2, 92) qui lit le second signal conservé dans le deuxième condensateur (75), la seconde section de lecture (43-2, 92) comprenant un quatrième condensateur (92) ;
un premier transistor d'amplification (72) qui délivre en sortie le premier signal par l'intermédiaire d'une première ligne de signal verticale, VSL (42-1), à la première section de lecture (43-1, 42-1, 91) ;
un second transistor d'amplification (76) qui délivre en sortie le second signal par l'intermédiaire d'une seconde ligne de signal verticale, VSL (42-2), à la seconde section de lecture (42-2, 43-2, 92) ;
un circuit différentiel dans lequel le premier signal provenant de la première section de lecture (43-1, 91) est entré au niveau d'une extrémité par l'intermédiaire du troisième condensateur (91) et le second signal provenant de la seconde section de lecture est entré au niveau d'une autre extrémité par l'intermédiaire du quatrième condensateur (92) ;
une section d'initialisation configurée pour initialiser le circuit différentiel, la section d'initialisation comportant un condensateur (99, 100, 203, 205) et un commutateur (97, 98, 202, 204) ; et dans lequel la section de conversion photoélectrique (61, 62, 63, 64, 65, 66, 67, 68) est incluse dans un premier substrat (121), le premier condensateur (71) et le deuxième condensateur (75) sont inclus dans un deuxième substrat (124), et le circuit différentiel est inclus dans un troisième substrat.

2. Dispositif d'imagerie (2, 2a, 2b, 2c, 2d) selon la revendication 1, comprenant en outre une première couche de câblage (122) empilée sur le premier substrat (121), et une seconde couche de câblage (123) empilée sur le deuxième substrat (124), dans lequel la première couche de câblage (122) et la seconde couche de câblage (123) sont agencées pour faire face l'une vers l'autre.

3. Dispositif d'imagerie (2, 2a, 2b, 2c, 2d) selon l'une quelconque des revendications précédentes, dans lequel le premier substrat (121) et le deuxième substrat (124) sont connectés électriquement par le biais de la première couche de câblage (122) et de la seconde couche de câblage (123).

4. Dispositif d'imagerie (2, 2a, 2b, 2c, 2d) selon l'une quelconque des revendications précédentes, dans lequel la section de conversion photoélectrique (61, 62, 63, 64, 65, 66, 67, 68) comporte une photodiode (61), un transistor de transfert (62), la diffusion flottante (63), un transistor de commutation (64), un transistor de réinitialisation de diffusion flottante (65), le transistor d'amplification intra-pixel (66), le dispositif d'imagerie (2, 2a, 2b, 2c, 2d) comportant en outre une section de mémoire (69) dans le deuxième substrat (124), la section de mémoire (69) comportant un premier transistor de commutation (70), le premier condensateur (71), un premier transistor d'amplification (72), un premier transistor de sélection (73), un second transistor de commutation (74), le deuxième condensateur (75), un second transistor d'amplification (76) et un second transistor de sélection (77).

5. Dispositif d'imagerie (2, 2a, 2b, 2c, 2d) selon l'une quelconque des revendications précédentes, dans lequel
le premier condensateur (71) conserve un niveau de réinitialisation, et
le deuxième condensateur (75) conserve un niveau de signal.

6. Dispositif d'imagerie (2, 2a, 2b, 2c, 2d) selon l'une quelconque des revendications précédentes, dans lequel
un signal de rampe est entré à l'extrémité précitée ou à l'autre extrémité précitée.

7. Dispositif d'imagerie (2, 2a, 2b, 2c) selon l'une quelconque des revendications précédentes, dans lequel
le circuit différentiel est un comparateur différentiel (93, 94, 95, 96, 101).

8. Dispositif d'imagerie (2, 2d) selon l'une quelconque des revendications 1 à 6, dans lequel
le circuit différentiel comporte un amplificateur différentiel (201).

9. Dispositif d'imagerie (2, 2b) selon l'une quelconque des revendications précédentes, dans lequel
un signal de rampe est entré à l'une parmi l'extrémité précitée et l'autre extrémité précitée, et un signal dans lequel une polarité du signal de rampe est inversée est entré à l'autre extrémité.

10. Dispositif d'imagerie (2, 2a) selon l'une quelconque des revendications 1 à 8, dans lequel
un signal de rampe est entré sur l'une parmi l'extrémité précitée et l'autre extrémité précitée, et un signal d'une tension constante est entré à l'autre extrémité.

11. Dispositif d'imagerie (2, 2a, 2b, 2c, 2d) selon l'une quelconque des revendications 1 à 4 et 6 à 10, dans lequel
le premier condensateur (71) conserve le premier signal converti photoélectriquement dans une première période d'exposition, et
le deuxième condensateur (75) conserve le second signal converti photoélectriquement dans une seconde période d'exposition.
